# EUROPEAN PATENT SPECIFICATION

(11) **EP 0 618 309 B1**
(45) Date of publication and mention of the grant of the patent: **16.09.1998**
(21) Application number: 93913505.9
(22) Date of filing: 11.06.1993
(51) Int. Cl.: C23C 24/08, B22F 1/00, C22C 9/00, C22C 1/04, C04B 41/51

(54) **METAL POWDER COMPOSITION FOR METALLIZATION AND METALLIZED SUBSTRATE**
METALLPULVERZUSAMMENSETZUNG ZUM METALLISIEREN UND METALLISIERTE SUBSTRATE
COMPOSITION DE POUDRE METALLIQUE POUR LA METALLISATION, ET SUBSTRAT METALLISE

(30) Priority: 21.10.1992 JP 282869/92
(43) Date of publication of application: 05.10.1994
(73) Proprietor: TOKIN CORPORATION, Sendai-shi Miyagi-ken 982 (JP)
(72) Inventor: WATABE, Youhei, Tokin Corporation, Sendai-shi, Miyagi 982 (JP); IWATA, Shinichi, Tokin Corporation, Sendai-shi, Miyagi 982 (JP); OHNO, Tomeji, Tokin Corporation, Sendai-shi, Miyagi 982 (JP)
(74) Representative: Prüfer, Lutz H., Dipl.-Phys.
(86) International application number: JP9300781
(87) International publication number: WO9409182

(56) References cited:
- EP-A- 0 028 819
- JP-A- 2 101 131
- JP-A- 4 280 880
- JP-A- 4 285 085
- JP-A-60 082 676
- JP-A-61 119 601
- JP-B-46 013 025
- JP-B-46 013 026

## Description

This invention relates to a metal powder composition for metallization which is for use in forming a conductor layer of a thick-film electronic circuit and in forming a copper circuit to diffuse heat generated by operation of elements and parts mounted on a ceramics substrate for an electronic apparatus, and also relates to a metallized substrate.

Generally, a substrate for an electronic circuit is required to have several characteristics, namely, to assure an excellent insulation property and a high mechanical strength, to prevent deterioration of electronic elements mounted thereon, to readily form a bond with a metal conductor, and to exhibit a high heat conductivity. Such a substrate can be made of alumina ceramics, nitride ceramics, and the like. On a single ceramics body, however, it is impossible to directly mount transistors, diodes, IC's, LSI's, and various other electronic parts used in an electronic apparatus.

In view of the above, a conventional electronic circuit is assembled by the use of a metallized film formed on a surface of the ceramics substrate. The metallized film is used as a conductor layer itself or serves to bond the ceramics substrate to a metal conductor. Preferably, the conductor layer or the metal conductor is made of an inexpensive material having a small electric resistance. Generally, copper is used. Heretofore, the metallized film is formed on the ceramics substrate by the steps of screen-printing a copper conductor paste onto the ceramics substrate to a thickness between 10 and 30 µm, drying the paste, and then firing the paste in a nitrogen atmosphere to form the circuit.

The metallized film formed on the ceramics substrate according to the above-mentioned method may be made of a copper conductor paste containing glass frit for nitride or oxide. However, a vertical tensile test for a square pad of 2mm long revealed that the bonding strength between the ceramics substrate and the metallized film was no more than about 2kg. In a high-temperature aging test at 150^{o}C, the bonding strength was reduced to less than a half of its initial value after the lapse of 100 hours or so. Particularly, the copper paste for nitride ceramics having an increased bonding strength and an improved reliability is unavailable at present.

On the other hand, Japanese Patent Publication JP-A-H04-280880 discloses a metal powder paste having a composition essentially consisting of 70 to 95 wt% Cu and 5 to 30 wt% Ti. This metal powder paste is free from deterioration at a high temperature and has an increased bonding strength for nitride and oxide. However, this paste is expensive and has a higher electric resistance than Cu because of its increased content of Ti. If the content of Ti is reduced to 5 wt% or less, however, the bond with the ceramics substrate is extremely weak.

In view of the above, it is a technical object of this invention to provide a metal powder composition for metallization, which is capable of providing a metallized film exhibiting an increased bonding strength and an improved reliability in an environmental test even if the content of Ti is less than 5 wt%, and to provide a metallized substrate.

The object is solved by a metallizing powder composition according to claim 1.

According to this invention, there is also provided a metallized ceramics substrate which is formed by applying, onto a surface of a ceramics substrate, a paste comprising the above-mentioned metal powder composition for metallization and a predetermined vehicle component, and then carrying out firing in a vacuum or an inactive gas atmosphere.

According to this invention, there is also provided a metallized ceramics substrate which is formed by applying, onto a surface of a ceramics substrate, a paste comprising the above-mentioned metal powder composition for metallization and a predetermined vehicle component, placing a metal foil on the paste, and thereafter carrying out firing in a vacuum or an inactive gas atmosphere to bond the metal foil.

### Brief Description of the Drawing

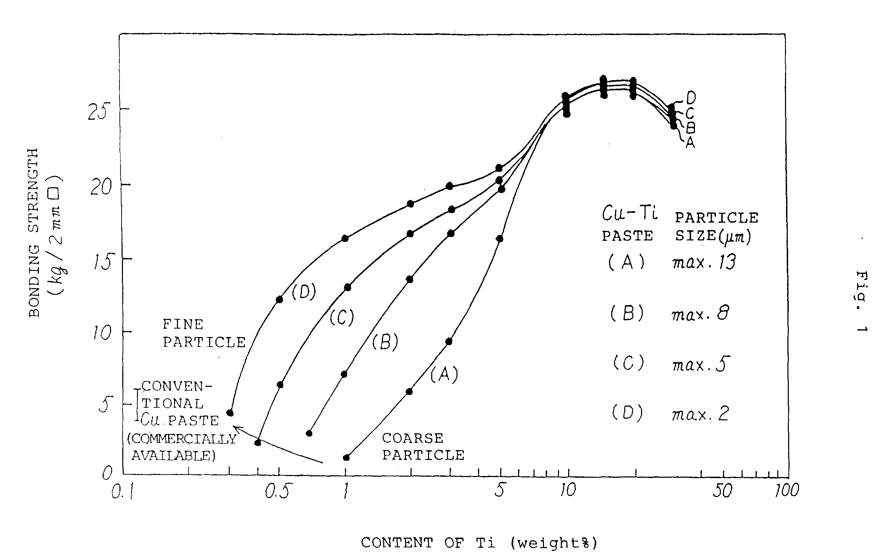

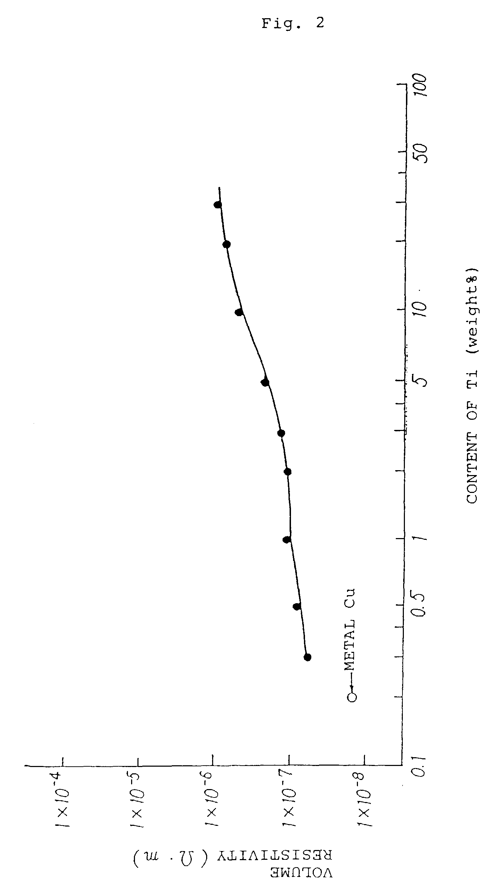

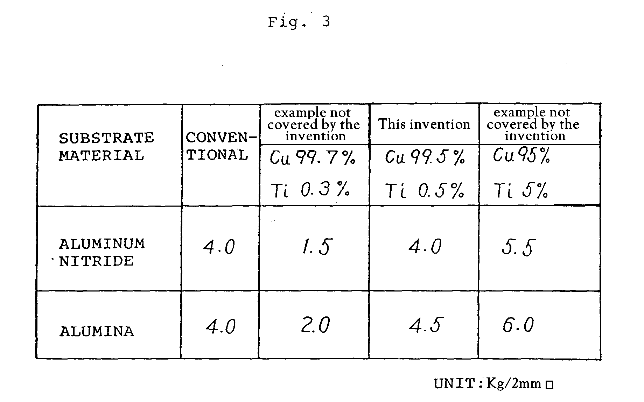

Fig. 1 shows a result of measurement of a bonding strength in a vertical tensile test for a metallized film according to this invention, Fig. 2 shows a result of measurement of a volume resistivity of the metallized film according to this invention, and Fig. 3 shows a result of measurement of a bonding strength in a peeling test for a copper foil used to form the metallized film according to this invention.

### Best Mode for Embodying the Invention

Now, description will be made as regards several embodiments of this invention.

### -First Embodiment-

A metal powder composition for metallization according to an embodiment of this invention essentially consists of more than 95 to 99.5% Cu as a main component and 0.5 to less than 5% Ti in weight %.

Copper fine powder (Cu) and titanium fine powder (Ti) having an average particle size not greater than 10 µm were preliminarily classified to be adjusted so that a metal component in a final paste form would have a particle size not greater than 13 µm but not smaller than 2 µm. Generally, the powder having a smaller particle size is more readily bonded to oxygen in the atmosphere to form oxide. This may result in deterioration of the bonding strength to the ceramics substrate. In this connection, classification of the metal powder was carried out in a nonoxidizing atmosphere. The Cu powder and the Ti powder obtained by classification and having different particle sizes were weighed and mixed into a predetermined composition ratio. Thus, the metal powder composition was prepared.

To the metal powder composition thus obtained, a commonly-used vehicle including a binder component of acrylic resin was added and sufficiently blended and dispersed by the use of a triple-roll mill. Thus, a paste adapted to screen printing was obtained. As regards the particle size of the paste, grinding particle sizes of the metal powder composition were graded by a particle gauge with respect to a maximum particle size of a conductor paste.

The paste according to this invention was printed on an aluminum nitride ceramics substrate and fired in a vacuum to form a metallized substrate. Fig. 1 shows the bonding strength as a result of a vertical tensile test for a square pad of 2mm long. The figure also shows, as a comparative example, those values obtained for a conventional copper paste containing glass frit and used in the aluminum nitride ceramics substrate.

According to this embodiment, when the content of Ti is not less than 10%, no substantial difference in bonding strength is observed irrespective of the scale of the particle size of the paste. When the content of Ti is between 10 and 5% and less than 5%, the bonding strength tends to increase if the particle size of the paste is reduced from a coarse-grained condition to a fine-grained condition. The paste of a smaller particle size has a remarkable effect upon the bonding strength particularly when the content of Ti is not greater than 5%. It is thus possible to make the metallized film have a greater bonding strength than the conventional copper paste containing glass frit even when the content of Ti is small.

Fig. 2 shows a volume resistivity of the metallized film which was prepared according to this embodiment. It is possible to achieve a decreased volume resistivity by reducing the content of Ti, particularly when the content of Ti falls within a range not greater than 5%.

As described above, the paste comprising a fine-grained component according to this invention provides the metallized film having an increased bonding strength to the aluminum nitride ceramics substrate even when the content of Ti is 5% in the composition. This paste includes no glass frit. Accordingly, no deterioration of the bonding strength was observed in a high-temperature aging test at 150^{o}C for 1000 hours to thereby prove a high reliability. In addition, the composition in the above-mentioned range successfully decreases the volume resistivity to a level lower than the conventional level.

### -Second Embodiment-

The paste according to this invention was prepared in the manner similar to the first embodiment, printed on a 96% alumina ceramics substrate, and fired in a vacuum to provide a metallized substrate. The similar test was carried out for a square pad of 2mm long. As a result, it was confirmed that the bonding strength was as high as 15kg and 18kg at the Ti content of 0.5% and 1%, respectively, when a particle size was equal to 2 µm. As to the volume resistivity, a similar result was obtained as in the first embodiment.

### -Third Embodiment-

The paste according to this invention was prepared in the manner similar to the first embodiment and printed and applied onto an aluminum nitride ceramics substrate and an alumina ceramics substrate, respectively. A copper foil having a thickness of 0.3mm was placed on the paste and fired to be bonded in a vacuum atmosphere. Fig. 3 shows a result of measurement of the bonding strength in a peeling test for a copper foil having a width of 2mm. A comparative example is also illustrated and shows a result of measurement for the similar copper foil which was bonded by the use of a conventional solder material.

The example having 99.7% Cu and 0.3% Ti shown in Fig. 3 is not covered by the invention. The example having 95% Cu and 5% Ti shown in Fig. 3 is also not covered by the invention.

As seen from the results illustrated in Fig. 3, the paste according to the third embodiment of this invention maintains the bonding strength between the copper foil and the ceramics substrate at a level equal to or superior to that obtained with the solder material in the conventional example, when the content of Ti is within a range between 0.5% and less than 5%.

### Effect of the Invention

According to this invention, the paste using the Cu and Ti powder contains the metal powder component of a reduced particle size. As a result, the bonding strength between the metallized film and the ceramics substrate is increased to a sufficient level in practical use, even when the content of Ti has a small value between 0.5 and less than 5%. It is thus possible to provide a metal powder composition for metallization capable of forming a metallized film which is highly reliable and which has a small volume resistivity, and to provide a metallized substrate.

### Industrial Applicability

As described above, the metal powder composition for metallization and the metallized substrate according to this invention are adapted to form the conductor layer of the thick-film electronic circuit on the ceramics substrate, and to form a copper circuit on the ceramics substrate in order to diffuse heat generated by operation of the elements and the parts mounted on the ceramics substrate for the electronic apparatus.

## Claims

1. A metallizing powder composition for use in forming a metallized film on a ceramic substrate, said composition comprising a paste of a powder mixture of Cu and Ti, said composition consisting essentially by weight of more than 95% to 99.5% Cu, and Ti ranging from 0.5% to less than 5%, said powder composition having a particle size ranging from about 2 µm to not greater than 13µm, wherein the composition does not include glass frits.

2. A metallized substrate obtained by applying said paste claimed in Claim 1 onto a substrate and firing said substrate together with said paste.

3. A metallized substrate obtained by applying said paste claimed in Claim 1 between a ceramics substrate and a metal foil and thereafter carrying out firing to thereby bond said ceramics substrate and said metal foil.

## Patentansprüche

1. Eine metallisierende Pulverzusammensetzung zur Verwendung beim Bilden eines metallisierten Filmes auf einem Keramiksubstrat, wobei die Zusammensetzung eine Paste aus einer Pulvermischung aus Cu und Ti aufweist, wobei die Zusammensetzung an Gewicht im wesentlichen nicht mehr als 95% bis 99.5% Cu und Ti im Bereich von 0.5% bis weniger als 5% aufweist, wobei die Pulverzusammensetzung eine Partikelgröße im Bereich von ungefähr 2 µm bis nicht mehr als 13 µm aufweist, wobei die Zusammensetzung keine Glasfritte enthält.

2. Ein metallisiertes Substrat, das erhalten wird durch Auftragen der Paste nach Anspruch 1 auf ein Substrat und Brennen des Substrats zusammen mit der Paste.

3. Ein metallisiertes Substrat, das erhalten wird durch Auftragen der Paste nach Anspruch 1 zwischen ein Keramiksubstrat und eine Metallfolie und danach Ausführen von Brennen zum dadurch Verbinden des Keramiksubstrats und der Metallfolie.

## Revendications

1. Composition de poudre métallique pour utilisation dans la formation d'une pellicule métallisée sur un substrat de céramique, cette composition comprenant une pâte d'un mélange pulvérulent de Cu et Ti, composition consistant essentiellement, en poids, en plus de 95 % à 99,5 % de Cu, avec du Ti compris entre 0,5 % et moins de 5 %, composition pulvérulente ayant une taille particulaire comprise entre environ 2 µm et au plus 13 µm, la composition n'incluant pas de verre fritté.

2. Substrat métallisé obtenu en appliquant ladite pâte revendiquée dans la revendication 1 sur un substrat et en portant au feu le substrat avec la pâte.

3. Substrat métallisé obtenu en appliquant la pâte revendiquée dans la revendication 1 entre un substrat de céramique et une feuille métallique puis en réalisant une mise à feu pour lier ainsi le substrat de céramique et la feuille métallique.
